Europäisches Patentamt

European Patent Office

Office européen des brevets

(19)

(11) Numéro de publication: **0 1 9 1 4 7 9**
**B1**

(12) **FASCICULE DE BREVET EUROPEEN**

(45) Date de publication du fascicule du brevet:
08.11.89

(51) Int. Cl.⁴: **H 03 H 3/02,** H 03 H 3/04,
H 03 H 9/05

(21) Numéro de dépôt: 86101786.1

(22) Date de dépôt: 13.02.86

(54) Procédé de fabrication de résonateurs à quartz à haute fréquence.

(30) Priorité: 13.02.85 FR 8502156

(43) Date de publication de la demande:
20.08.86 Bulletin 86/34

(45) Mention de la délivrance du brevet:
08.11.89 Bulletin 89/45

(84) Etats contractants désignés:
CH DE GB LI

(56) Documents cités:
PATENTS ABSTRACTS OF JAPAN, vol. 8, no. 256 (E-280)
[1693], 22 novembre 1984; & JP - A - 59 128 814 (NIHON
DENPA KOGYO K.K.) 25-07-1984
PATENTS ABSTRACTS OF JAPAN, vol. 8, no. 131 (E-251)
[1568], 19 juin 1984; & JP - A - 59 41 914 (SEIKO DENSHI
KOGYO K.K.) 08-03-1984
PATENTS ABSTRACTS OF JAPAN, vol. 3, no. 115
(E-140), 22 septembre 1979; & JP - A - 54 92 087 (SUWA
SEIKOSHA K.K.) 20-07-1984
PATENTS ABSTRACTS OF JAPAN, vol. 4, no. 185 (E-38)
[667], 19 décembre 1980; & JP - A - 55 127 717
(TOUHOKU KINZOKU KOGYO K.K.) 02-10-1980

(73) Titulaire: Eta SA Fabriques d'Ebauches,
Schild-Rust-Strasse 17, CH-2540 Granges (CH)

(72) Inventeur: Studer, Bruno, Lindenstrasse 2,
CH-4533 Riedholz (CH)

(74) Mandataire: Caron, Gérard et al, ICB Ingénieurs
Conseils en Brevets SA Passage Max. Meuron 6,
CH-2001 Neuchâtel (CH)

## Description

La présente invention est relative à un procédé de fabrication de résonateurs à quartz travaillant dans une gamme de fréquences relativement élevée pouvant aller typiquement de 20 à 100 MHz. Plus particulièrement, l'invention se rapporte à des résonateurs à quartz fonctionnant dans le mode à cisaillement d'épaisseur.

On sait que dans ce genre de résonateurs, la fréquence de fonctionnement dépend directement de l'épaisseur du cristal actif (US-A-3 694 677). Pour atteindre des fréquences aussi élevées que celles mentionnées ci-dessus, l'épaisseur de l'élément résonnant est extrêmement faible (de l'ordre de quelques microns à une centaine de microns), de sorte que les opérations d'usinage mécanique sont totalement inappropriées.

En outre, la manipulation des éléments est très délicate et au cours de l'utilisation, des chocs peuvent être fatals et provoquer la rupture de l'élément.

C'est pourquoi, dans le brevet américain précité, on envisage d'une part de munir l'élément résonateur d'une bordure de renfort, nettement plus épaisse que l'est le résonateur lui-même et, d'autre part, de ne procéder de préférence qu'à des opérations d'usinage non mécaniques telles que la gravure chimique ou ionique tout au moins dans le dernier stade du processus conduisant à l'épaisseur souhaitée de l'élément résonnant. Si ces deux précautions peuvent dans une certaine mesure résoudre les problèmes mécaniques évoqués ci-dessus, il subsiste néanmoins des difficultés qui résident dans le couplage trop important qu'a l'élément résonateur avec la bordure de renfort. Ceci conduit à des résonances parasites et d'une façon générale à une caractéristique médiocre du résonateur.

Le US-A-4 135 108 décrit un résonateur à quartz du type dans lequel le quartz est monté en tant que diélectrique entre les armatures d'un condensateur, ces armatures étant prévues sur des plaques qui tiennent le résonateur en place. A cet effet, ce dernier peut comprendre un anneau périphérique coincé entre les plaques et séparé de l'élément résonateur proprement dit par des zones amincies qui peuvent prendre la forme de simples pattes de connexion radiales entre l'anneau périphérique et l'élément résonateur.

L'anneau, les pattes amincies et l'élément résonateur sont d'une seule pièce et la forme de l'ensemble est obtenue par usinage tel que l'abrasion, l'attaque chimique ou analogue. Dans certains cas, cet ensemble peut avoir une épaisseur globale uniforme, à l'exception des pattes de connexion, les surfaces principales étant parallèles. L'ajustage en fréquence de l'élément résonnant peut être obtenu par enlèvement de matière, mais une telle opération d'usinage précis implique alors la totalité de la surface ou des surfaces principales de l'ensemble composé de l'anneau, des pattes et de la partie centrale résonnante, de sorte qu'elle entraîne un affaiblissement mécanique général de cet ensemble y compris de l'anneau extérieur. Celui-ci perd donc son rôle de renfort mécanique et ne sert en définitive que d'organe de fixation. Bien que cette disposition conduise à un meilleur découplage par rapport au support, il reste qu'elle est fragile et supporte difficilement les manipulations. Or, si l'anneau est relativement mince, la réduction de l'épaisseur de la partie centrale ne peut être aussi importante que l'on pourrait le souhaiter, compte tenu des fréquences élevées de résonance à obtenir.

On connaît également, à savoir du document JP-A-59 128 814 un résonateur comprenant une partie centrale active bordée d'un cadre de renfort auquel elle est mécaniquement reliée par un organe de connexion entourant la totalité de ladite partie active. Le résonateur est tel que l'épaisseur du cadre de renfort est supérieure à l'épaisseur de la partie active, elle-même supérieure à l'épaisseur de l'organe de connexion. Une telle structure présente un inconvénient majeur. En effet, lorsque le résonateur vibre à une fréquence fondamentale élevée, l'organe de connexion dans son ensemble est soumis à des vibrations et par conséquent à des contraintes mécaniques élevées si bien qu'il apparaît des risques de rupture.

L'invention a pour but de fournir un procédé de fabrication d'un résonateur à quartz et le produit en résultant, qui permettent d'allier la rigidité mécanique du résonateur à une fréquence aussi élevée que 100 MHz.

Elle a donc pour objet un procédé de fabrication de résonateurs à quartz, notamment à coupe AT et à mode de vibration en cisaillement d'épaisseur, chaque résonateur comportant un élément central actif entouré d'un cadre de renfort dont il est séparé par au moins un organe de connexion de moindre épaisseur, ce procédé consistant à soumettre un substrat en quartz à faces parallèles à des opérations sélectives de gravure chimique et de photolithographie, ce procédé étant caractérisé en ce qu'il consiste à réduire l'épaisseur du substrat dans la zone marginale correspondant à l'organe de connexion de chaque résonateur, tout en conservant celles correspondant audit élément central et audit cadre de renfort puis à réduire davantage l'épaisseur de ladite zone marginale simultanément à une réduction d'épaisseur de la partie centrale, cette deuxième réduction d'épaisseur n'affectant pas non plus l'épaisseur dudit cadre de renfort.

L'invention a également pour objet un résonateur obtenu par le procédé tel que défini ci-dessus.

Ce résonateur, conforme à l'invention, présente l'avantage d'allier une fréquence fondamentale élevée à une résistance mécanique et un découplage des vibrations très satisfaisants.

D'autres caractéristiques et avantages de l'invention apparaîtront plus clairement à la lecture de la description qui suit de plusieurs modes de mise en œuvre de l'invention, donnés à titre d'exemples non limitatifs.

La description se réfère aux dessins annexés sur lesquels:

– les figures 1A à 9B illustrent respectivement par des vues en coupe et des vues en plan, un mode de mise en œuvre préféré du procédé de fabrication suivant l'invention;

– les figures 10 et 11 sont des vues en plan de deux variantes d'un résonateur obtenues par ce procédé.

Selon ce procédé, on prépare tout d'abord une plaquette en quartz (Wafer) selon la technique classique. Cette plaquette est de préférence de coupe AT pour permettre l'établissement d'un mode de cisaillement d'épaisseur dans les résonateurs que l'on se propose d'y fabriquer.

Cette plaquette ou substrat 1 est ensuite revêtue sur ses deux faces de métallisations pouvant être constituées de deux couches superposées métalliques, respectivement une couche de chrome 2 d'environ 200 Å d'épaisseur et en une couche d'or 3 d'environ 2000 Å.

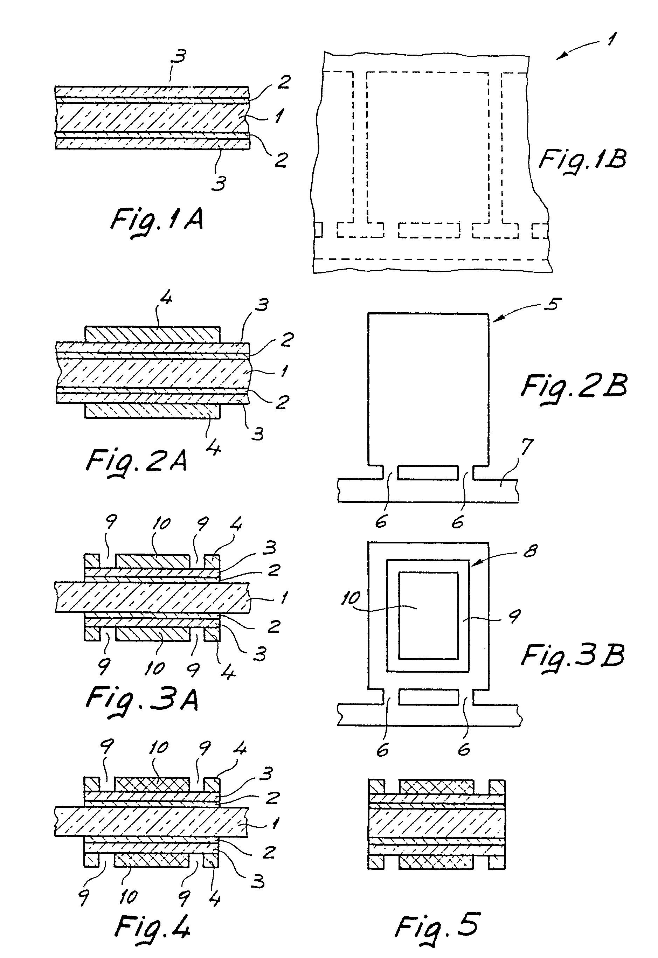

Ensuite, on délimite sur le substrat les contours des résonateurs à obtenir ainsi que celui des réseaux de connexions mécaniques qui permettent de manipuler les résonateurs au cours des divers stades du procédé. Cette étape consiste (figure 2A) à apporter toujours sur les deux faces du substrat, un masque 4 en photoresist. La figure 2B montre ainsi le contour d'un seul résonateur 5 que l'on voit muni de pattes de connexion 6 destinées à relier le résonateur à une bande de connexion 7.

On procède ensuite à une attaque chimique sélective des couches d'or puis de chrome pour mettre à nu les faces du substrat en dehors des zones correspondant aux résonateurs, c'est-à-dire dans les zones qui ne sont pas masquées par le photo-resist 4.

L'étape suivante du procédé consiste à placer sur les deux faces du substrat un masque permettant de n'exposer à la lumière que des zones en forme de cadre 8 (figure 3B) dans chaque partie du substrat correspondant à un résonateur. On expose à la lumière et on développe le photo-resist de manière à former une rainure 9 (figure 3A) dans le photo-resist.

On procède alors à la mise en place d'un autre masque sur l'ensemble ainsi traité, ce masque permettant d'exposer à la lumière les parties centrales 10 des résonateurs délimités par les rainures 9. Toutefois, on ne procède pas encore au développement de ces parties centrales après l'exposition à la lumière ce qui est représenté par des hâchures croisées sur les figures. Le substrat présente alors la configuration représentée à la figure 4.

On procède alors à l'attaque chimique du substrat lui-même pour séparer les résonateurs les uns des autres tout en conservant la bande de connexion 7 et les pattes de connexion 6 représentées aux figures 2B et 3B. Le substrat a alors la configuration représentée sur la figure 5.

L'étape suivante consiste à effectuer une attaque chimique sélective des portions de métallisation se trouvant en-dessous des rainures 9 du photo-resist suivie d'une attaque du quartz permettant de ménager dans le substrat lui-même une rainure 11 à l'aplomb des rainures 9 du pho-

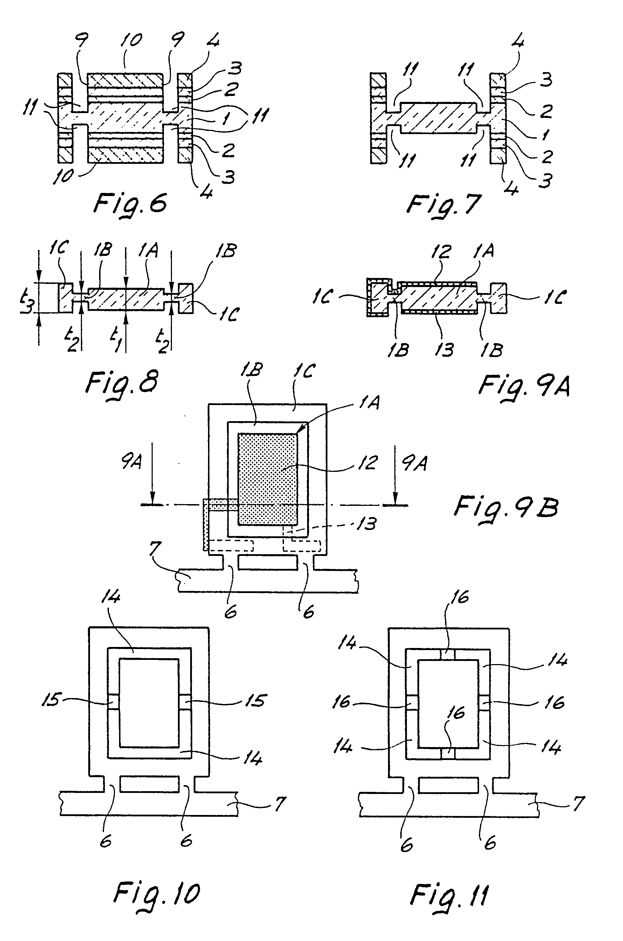

to-resist. Le substrat présente alors la configuration de la figure 6.

Le stade suivant consiste à développer le photo-resist déjà exposé de la partie centrale 10 suivi d'une attaque sélective des couches de métal sous-jacentes pour mettre à nu le quartz de la partie centrale.

La figure 7 montre la configuration qui est obtenue après les opérations qui viennent d'être décrites. Le substrat 1 comporte une partie centrale 1A destinée à devenir le résonateur proprement dit, une partie de connexion mécanique 1B qui va assurer le découplage des vibrations de la partie centrale, et un cadre de renfort 1C entourant l'ensemble. Pour l'instant la partie 1C est encore couverte de métallisations et de photo-resist.

A partir de la configuration de la figure 7 et suivant une caractéristique essentielle de l'invention, on procède alors de nouveau à une attaque chimique du substrat pour en réduire et ajuster l'épaisseur, c'est-à-dire de la partie active 1A et de la partie de connexion 1B.

Ensuite, le restant du photo-resist et les couches de métal subsistant encore sont enlevés moyennant quoi on obtient la configuration de la figure 8.

Le dernier stade du procédé consiste à apporter deux électrodes 12 et 13 par métallisation conformément aux figures et 9A et 9B.

Il y lieu de noter deux remarques importantes à propos du procédé que l'on vient de décrire.

1. Le résonateur qui est finalement obtenu comporte ainsi la partie centrale 1A d'épaisseur $t_1$ déterminant la fréquence fondamentale. L'épaisseur $t_1$ peut être choisie entre 16µ à 160µ pour une fréquence pouvant aller de 100 MHz à 10 MHz environ, ces valeurs n'étant indiquées ici qu'à titre indicatif. La partie centrale est entourée de la partie de connexion 1B d'épaisseur $t_2$ qui peut être choisie dans une fourchette allant de 10µ à une valeur s'approchant de $t_1$, une valeur inférieure de 5% donnant déjà d'excellents résultats sur le plan du découplage des vibrations. Enfin, la partie de connexion 1B est entourée d'une ceinture ou d'un cadre de renfort 1C dont l'épaisseur $t_3$ peut être nettement plus élevée que $t_1$ et $t_2$, une valeur située entre 0,08 et 0,2 mm s'étant avérée favorable.

2. Toutes les opérations de masquage sont effectuées avant que les résonateurs ne soient séparés les uns des autres, l'exposition de la partie centrale 10 (figure 3B) ayant lieu préalablement à l'opération de découpe (passage de la figure 4 à la figure 5). Cette caractéristique particulière permet de réduire considérablement les défauts de fabrication puisque toutes les manipulations intensives nécessaires pour le masquage et l'insolation sont réalisées alors que le substrat de la pastille de quartz possède encore son intégrité.

Dans ce qui précède, on a supposé que la partie active 1A du résonateur est attachée au cadre de renfort 1C sur toute la périphérie de cette partie active. Or, comme représenté aux figures 10 et 11, on peut également réaliser des fentes 14 traversant le substrat de part en part, lorsqu'on procède à l'opération de séparation des résonateurs (passage de la figure 4 à la figure 5). Il en résulte en définitive que le résonateur comporte simplement des pattes de connexion reliant le cadre de renfort à la partie active. Sur la figure 10, ces pattes de connexion portent la référence 15 et sont au nombre de deux tandis que sur la figure 11 les pattes sont indiquées par la référence 16 et sont au nombre de quatre.

Bien entendu, d'autres variantes peuvent être imaginées à partir de ce que l'on vient de décrire. En particulier, il est possible de faire varier le nombre des pattes de connexion à la manière des réalisations des figures 10 et 11. En particulier, il est possible de ne prévoir qu'une seule de ces pattes, de manière à obtenir un montage en porte-à-faux de la partie centrale du résonateur.

## Revendications

1. Procédé de fabrication de résonateurs à quartz, notamment à coupe AT et à mode de vibration en cisaillement d'épaisseur, chaque résonateur comportant un élément central actif (1A) entouré d'un cadre de renfort (1C) dont il est séparé par au moins un organe de connexion (1B) de moindre épaisseur, ce procédé consistant à soumettre un substrat en quartz à faces parallèles (1) à des opérations sélectives de gravure chimique et de photolithographie, ce procédé étant caractérisé en ce qu'il consiste à réduire l'épaisseur du substrat (1) dans la zone marginale (8) correspondant à l'organe de connexion (1B) de chaque résonateur, tout en conservant celles correspondant audit élément central (1A) et audit cadre de renfort (1B), puis à réduire davantage l'épaisseur de ladite zone marginale (11) simultanément à une réduction d'épaisseur de la partie centrale, cette deuxième réduction d'épaisseur n'affectant pas non plus l'épaisseur dudit cadre de renfort (1C).

2. Procédé suivant la revendication 1 caractérisé en ce qu'il consiste, préalablement à l'exécution de la première réduction d'épaisseur, à revêtir le substrat (1) d'une couche de photo-resist (4), à ouvrir une rainure (9) dans cette couche au-dessus de ladite zone marginale (8) et à attaquer la zone du substrat sousjacente jusqu'à obtention de la première épaisseur.

3. Procédé suivant la revendication 2 caractérisé en ce que la seconde opération de réduction d'épaisseur consiste à éliminer la couche de photo-resist au-dessus de ladite partie centrale (1A) du substrat (1) puis à attaquer les parties (1A, 1B) mises à nu du substrat, jusqu'à obtention de l'épaisseur ($t_1$) de cette partie centrale (1A) correspondant à la fréquence à obtenir.

4. Procédé suivant l'une quelconque des revendications 1 à 3, caractérisé en ce que ladite première réduction d'épaisseur est précédée d'une opération de découpe par attaque chimique dudit substrat pur délimiter les résonateurs dans celui-ci.

5. Procédé suivant les revendications 2 et 4 prises ensemble caractérisé en ce que ladite opération de découpe est exécutée à l'aide de ladite couche de photo-resist (4).

6. Procédé suivant la revendication 5 caractérisé en ce que ladite opération de découpe consiste également à pratiquer au moins une fente (14) dans le substrat à l'endroit de ladite zone marginale (1B) à l'exception du ou desdits organes de connexion (1B, 15, 16).

7. Procédé suivant la revendication 6 caractérisé en ce qu'il consiste à insoler ladite couche de photo-resist (4) dans la zone correspondant à ladite partie centrale (1A) préalablement à ladite opération de découpe et à développer la partie correspondante (10) de cette couche de photo-resist (9) postérieurement à ladite opération de découpe mais antérieurement à ladite première opération de réduction d'épaisseur.

8. Résonateur obtenu selon le procédé suivant l'une quelconque des revendications précédentes comprenant une partie centrale active (1A) d'épaisseur $t_1$ bordée d'un cadre de renfort d'épaisseur $t_3$ auquel elle est reliée mécaniquement par un ensemble de connexion d'épaisseur $t_2$, avec $t_3 > t_1 > t_2$, caractérisé en ce que l'ensemble de connexion se présente sous la forme d'une pluralité de pattes (15, 16), le restant de ladite zone marginale étant occupé par une fente (14) traversant le substrat d'une face à l'autre.

## Patentansprüche

1. Verfahren zum Herstellen von Quarzresonatoren, insbesondere mit AT-Schnitt und Dickenscherschwingungsmodus, wobei jeder Resonator eine zentrale aktive Partie (1A) umfasst, umgeben von einem Verstärkungsrahmen (1C), von dem es durch mindestens ein Verbindungsorgan (1B) verringerter Dicke getrennt ist, welches Verfahren darin besteht, ein Quarzsubstrat (1) mit parallelen Seiten selektiven Arbeitsgängen der Chemogravur und Photolithographie auszusetzen, wobei dieses Verfahren dadurch gekennzeichnet ist, dass es in einer Dickenverringerung des Substrats (1) in der dem Verbindungsorgan (1B) entsprechenden marginalen Zone (8) jedes Resonators besteht unter Konservierung jener, die der zentralen Partie (1A) und dem Verstärkungsrahmen (1B) entsprechen, aus nachfolgendem weiterem Verringern der Dicke der marginalen Zone (11) simultan mit einer Dickenverringerung der zentralen Partie, wobei auch diese zweite Dickenverringerung nicht die Dicke des Verstärkungsrahmens (1C) beeinflusst.

2. Verfahren nach Anspruch 1, dadurch gekennzeichnet, dass es, vor der ersten Dickenverringerung, aus einer Beschichtung des Substrats (1) mit einer Photoresist-Schicht (4), dem Öffnen einer Rille (9) in dieser Schicht über der marginalen Zone und dem Abtrag der unterliegenden Zone des Substrats bis zum Erreichen der ersten Dicke besteht.

3. Verfahren nach Anspruch 2, dadurch gekennzeichnet, dass der zweite Arbeitsgang der Dickenverringerung darin besteht, die Photoresist-Schicht über der zentralen Partie (1A) des Substrats zu entfernen und die freigelegten Par-

tien (1A, 1B) abzutragen bis zum Erreichen der Dicke ($t_1$) dieser zentralen Partie (1A) entsprechend der zu erzielenden Frequenz.

4. Verfahren nach einem der Ansprüche 1 bis 3, dadurch gekennzeichnet, dass der ersten Dickenverringerung ein Arbeitsgang des Zertrennens durch chemischen Abtrag des Substrats vorausgeht, um die Resonatoren in jenem zu begrenzen.

5. Verfahren nach Ansprüchen 2 und 4 in Kombination, dadurch gekennzeichnet, dass der Zertrennarbeitsgang mit Hilfe der genannten Photoresist-Schicht ausgeführt wird.

6. Verfahren nach Anspruch 5, dadurch gekennzeichnet, dass der Zertrennarbeitsgang gleichermassen darin besteht, mindestens einen Spalt (14) in das Substrat am Ort der marginalen Zone (1B) einzubringen mit Ausnahme des oder der Verbindungsorgans/organe (1B, 15, 16).

7. Verfahren nach Anspruch 6, dadurch gekennzeichnet, dass es darin besteht, die Photoresist-Schicht (4) in der Zone entsprechend der zentralen Partie (1A) vor dem Zertrennarbeitsgang zu belichten und die entsprechende Zone (10) der Photoresist-Schicht (4) nach dem Zertrennarbeitsgang, jedoch vor dem ersten Dickenverringerungsarbeitsgang zu entwickeln.

8. Resonator, erhalten durch ein Verfahren nach einem der vorangehenden Ansprüche, umfassend eine zentrale aktive Partie (1A) der Dicke $t_1$, umgeben von einem Verstärkungsrahmen der Dicke $t_3$, mit dem sie mechanisch durch eine Gruppe von Verbindungen der Dicke $t_2$ verbunden ist, mit $t_3 > t_1 > t_2$, dadurch gekennzeichnet, dass die Gruppe von Verbindungen in Form einer Mehrzahl von Laschen (15, 16) vorliegt, wobei der Rest der marginalen Zone von einem Spalt (14) eingenommen wird, der das Substrat von einer Seite zur andern durchsetzt.

## Claims

1. A process for manufacturing a quartz resonator, especially for AT-cut resonator operating in the thickness shear vibration mode, each resonator comprising an active central portion (1A) surrounded by a reinforcing frame (1C) from which it is separated by at least one connecting member (1B) of a smaller thickness, said process consisting in subjecting a quartz substrate (1) with parallel faces to selective operations of chemical etching and photolithography, this process being characterized by the operations of reducing the thickness of the substrate (1) in the marginal area (8) corresponding to said connecting member (1B) of each resonator whilst preserving those areas corresponding to said central portion (1A) to said reinforcing frame (1B), further reducing the thickness of said marginal area (11) at the same time as reducing the thickness of said central portion, said further reduction again not affecting the thickness of said reinforcing frame (1C).

2. A process according to claim 1, characterized in that prior to carrying-out of said first reduction in thickness, said substrate (1) is coated with a layer of photoresist (4), a groove (9) is formed in said layer above said marginal area (8), the underlying area of said substrate being attacked until said first reduced thicknes is obtained.

3. A process according to claim 2, characterized in that said second thickness reducing operation consists in eliminating said layer of photoresist above said central portion (1A) of said substrate (1) and then attacking the exposed portions (1A, 1B) of said substrate until said central portion (1A) reaches the thickness ($t_1$) corresponding to the frequency to be obtained.

4. A process according to any one of claims 1 to 3, characterized in that said first reduction in thickness is preceded by a scribing operation, effected by chemical attack of said substrate in order to define a plurality of resonators in said substrate.

5. A process according to claims 2 and 4 taken together, characterized in that said scribing operation is effected by means of said photoresist layer (4).

6. A process according to claim 5, characterized in that said scribing operation also consists in making at least one slit (14) in the part of said marginal area (1B) of said substrate excluding said connecting member or members (1B, 15, 16).

7. A process according to claim 6, characterized in that said photoresist layer (4) is exposed to light in the area corresponding to said central portion (1A) prior to said scribing operation and the ation but before said first thickness reducing operation.

8. A resonator obtained in accordance with the process according to any one of the preceding claims comprising an active central portion (1A) of thickness $t_1$ surrounded by a reinforcing frame of thickness $t_3$ to which said central portion is joined mechanically by connecting means of thickness $t_2$, with $t_3 > t_1 > t_2$, characterized in that the connecting means is in the form of a plurality of bridges (15, 16), the rest of a marginal area being occupied by a slit (14) going right through the substrate from one face to the other. corresponding portion (10) of said layer of photoresist (4) is developed after said scribing oper-

Fig.1A

Fig.1B

Fig.2A

Fig.2B

Fig.3A

Fig.3B

Fig.4

Fig.5

Fig.6

Fig.7

Fig.8

Fig.9A

Fig.9B

Fig.10

Fig.11